# EUROPEAN PATENT APPLICATION

(11) **EP 1 129 990 A1**
(43) Date of publication of application: **05.09.2001**
(21) Application number: 00307617.1
(22) Date of filing: 04.09.2000
(51) Int. Cl.: C01B 31/02, H01J 9/02, C23C 16/26

(54) **Process for controlled growth of carbon nanotubes**

(30) Priority: 25.02.2000 US 512873
(71) Applicant: LUCENT TECHNOLOGIES INC., Murray Hill, New Jersey 07974-0636 (US)
(72) Inventor: Bower, Christopher Andrew, Chapel Hill, North Carolina 27514 (US); Jin, Sungho, Millington, New Jersey 07946 (US); Zhu, Wei, Warren, New Jersey 07059 (US)
(74) Representative: Williams, David John

(57) **Abstract**

The process of the invention is capable of providing conformably-aligned nanotubes perpendicular to the local surface of a flat or non-flat substrate, with an average deviation less than 15°, while also allowing control over the nanotube diameter, length, and location. In particular, the invention uses a high frequency plasma enhanced chemical vapor deposition (PECVD), advantageously with an acetylene-ammonia chemistry, to provide such results, typically with cobalt as a catalyst metal.

## Description

### BACKGROUND OF THE INVENTION

### Field of the Invention

The invention relates to carbon nanotubes, in particular, processes for attaining controlled growth of nanotubes.

### Discussion of the Related Art

Carbon nanotubes are cylindrical shells of graphitic sheets typically having diameters of 1-50 nm and lengths of 1-10 µm. They offer unique physical properties that are potentially useful in a variety of nanometer-scale devices and technologies. See, e.g., C. Dekker, "Carbon nanotubes as molecular quantum wires," Physics Today, May 1999. Most of those envisioned applications, however, require that the nanotubes be grown in a highly controlled fashion, i.e., with their orientation, as well as their diameter, length, location and microstructure, controllable and reproducible. There have been reports of growth of aligned nanotubes using porous templates (W. Z. Li et al., "Large Scale Synthesis of Aligned Carbon Nanotubes," Science, Vol. 274, 1701 (1996); S. Fan et al., "Self-oriented regular arrays of carbon nanotubes and their field emission properties," Science, Vol. 283, 512 (1999); J. Li et al., "Highly ordered carbon nanotubes arrays for electronic applications," Appl. Phys. Lett., Vol. 75, 367 (1999)). Other papers on growing aligned nanotubes have described dc plasma assisted hot filament deposition (Z. F. Ren et al., "Synthesis of large arrays of well-aligned carbon nanotubes on glass," Science, Vol. 282, page 1105 (1998)). But a process providing substantial control of both the geometric and structural properties of the tubes has been elusive, and a sound understanding of the growth-structure-property relationship is lacking. Moreover, formation of nanotubes conformably aligned perpendicular to the local surface on geometrically non-flat surfaces has not been reported, by any method.

Thus, improved processes for attaining controlled growth of carbon nanotubes are desired.

### SUMMARY OF THE INVENTION

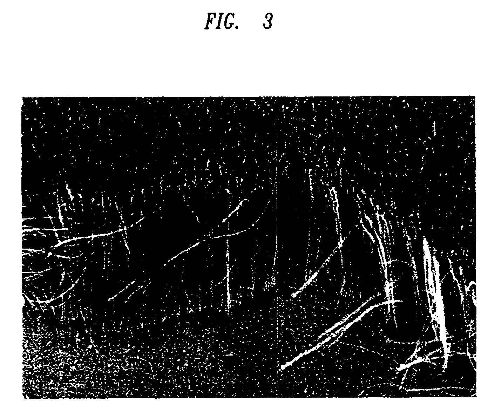

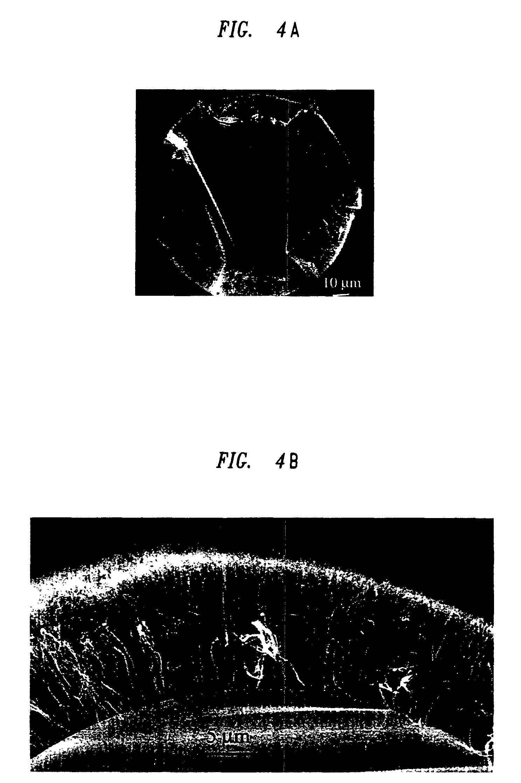

The invention provides a process capable of providing nanotubes conformably-aligned perpendicular to the local surface, while also allowing control over the nanotubes' diameter, length, and location. (Conformably-aligned perpendicular to the local surface means that the nanotubes are perpendicular to the substrate surface at the point of attachment to the surface, regardless of the surface curvature or contour, with an average deviation from perpendicular of less than 15°, as measured by x-ray diffraction. See, e.g., Figs. 3, 4A, and 4B.) In particular, the invention uses high frequency plasma enhanced chemical vapor deposition (PECVD), typically with microwave-ignited plasma, and advantageously with an acetylene-ammonia chemistry, to provide such results, typically with cobalt as a catalyst metal. Previously, those in the art have only been able to produce randomly-oriented carbon nanotubes with a microwave PECVD process. (See L. C. Qin et al. "Growing carbon nanotubes by microwave plasma-enhanced chemical vapor deposition," Appl. Phys. Lett., Vol. 72, 3437(1998); Kuttel et al. "Electron field emission from phase pure nanotube films grown in a methane/hydrogen plasma," Appl. Phys. Lett., Vol. 73. 2113 (1998).)

The extraordinarily high extent of conformal alignment - on both flat and non-flat surfaces - appears to be due to the electrical self-bias imposed on the substrate by the plasma, the field line of which is perpendicular to the substrate surface. (See, e.g., B. Chapman, Glow Discharge Processes, John Wiley & Sons, page 143, (1980).) The ammonia-based gas chemistry appears to contribute to the desirable alignment as well, although the exact nature of the ammonia's contribution is not clear. In addition to the conformal orientation, its was found that by selecting a particular thickness for the catalyst layer, it was possible to obtain nanotubes of a desired diameter, while the length of the nanotubes is determined by the duration of the PECVD process. And, by patterning the catalyst metal, it is possible to form nanotubes in particular locations on a substrate.

Thus, the invention constitutes an extremely useful tool for attaining nanotubes with controllable alignment, diameter, length, and location.

### BRIEF DESCRIPTION OF THE DRAWINGS

Fig. 1 illustrates an apparatus suitable for performing a microwave plasma enhanced chemical vapor deposition process.

Figs. 2A-2E illustrate a nucleation and growth model for nanotubes in the PECVD process.

Fig. 3 is a scanning electron microscope micrograph showing conformably-aligned nanotubes on a flat surface formed according to the invention.

Figs. 4A and 4B shows scanning electron microscope micrographs of conformably-aligned nanotubes on non-flat surfaces formed according to the invention.

Fig. 5 shows the relationship of catalyst layer thickness to diameter of the grown nanotubes.

Fig. 6 shows the relationship of nanotube length to the duration of the PECVD process.

Fig. 7 shows an apparatus suitable for increasing the speed of nanotube fabrication according to the invention.

### DETAILED DESCRIPTION OF THE INVENTION

According to the invention, carbon nanotubes are grown in a manner that provides conformably-aligned nanotubes perpendicular to the local surface of a substrate. (As noted above, conformably-aligned perpendicular to the local surface means that the nanotubes are perpendicular to the substrate surface at the point of attachment to the surface, regardless of the surface curvature or contour, with an average deviation from perpendicular of less than 15°, as measured by x-ray diffraction.) It is also possible to select the process parameters to provide a particular nanotube diameter, length, and/or location, i.e., a level of control over the nanotube growth is attainable.

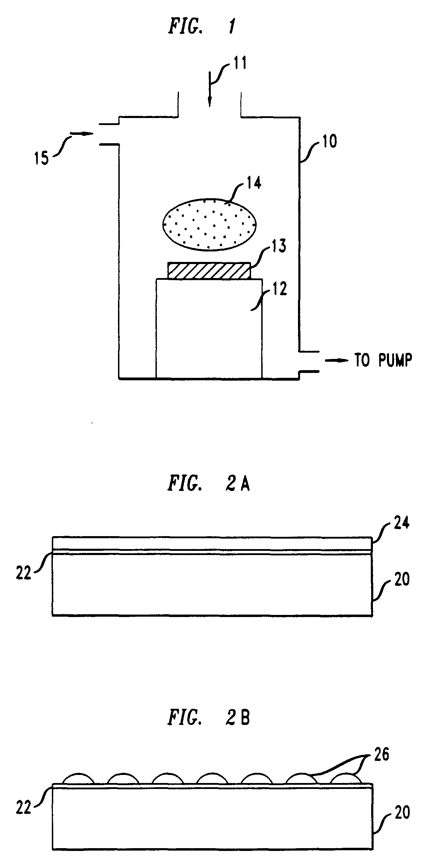

Specifically, multi-wall carbon nanotubes are formed by high frequency plasma enhanced chemical vapor deposition (PECVD), where the high frequency is generally provided by RF or microwave sources. (As used herein, high frequency indicates 50 kHz or greater. RF or radio frequency indicates 50 kHz to 300 MHz, and microwave frequency indicates 300 MHz to 300 GHz.) A microwave PECVD technique is generally known as a technique for depositing diamond thin films, as discussed, for example, in P. K. Bachmann and R. Messier, "Emerging technology of diamond thin films," Chemical and Engineering News, May 15, 1989. As shown in Fig. 1, an MPECVD system contains a vacuum chamber 10 equipped with a microwave source 11 and a heater 12. The substrate 13 is placed on the heater 12, and a gas 15, e.g., an ammonia and acetylene mixture, is directed into the chamber 10. A plasma 14 is ignited above the substrate from the gas 15 by, in this embodiment, microwave energy. Typical microwave energy frequencies are 2.45 GHz and 915 MHz. (A typical RF frequency is 13.56 MHz.) The substrate temperature is generally kept between 500 and 1000°C. The typical plasma parameters include a microwave power input of 1-5 kW and a gas pressure of 10-100 Torr.

The high level of conformal alignment, reflected in the Examples below, is provided by the unique characteristics of the high frequency PECVD process employed. The high frequency PECVD is performed with a gaseous carbon-based chemistry, advantageously an acetylene-ammonia chemistry. The acetylene (C₂H₂) provides the carbon species necessary for nanotube formation, although it is also possible to use other carbon-containing gases, such as methane and carbon dioxide, as the carbon source. The ammonia appears to promote or modify chemical reactions in the gas phase (such as decomposition of acetylene) as well as on the substrate surface (such as reactions involving carbon and catalyst metal as well as etching of nanotubes), although the exact nature of its role is not clear. The conformal alignment is believed to occur due to the high frequency PECVD process's creation of an electrical self-bias potential on the substrate surface. The field line of the potential is perpendicular to the surface of the substrate, and the nanotubes tend to grow along these field lines. It is believed that the relatively heavy molecular mass of the ions in the ammonia-acetylene plasma chemistry, particularly the ammonia, help to sustain a sufficiently strong electrical field near the surface. Specifically, because the self-bias potential is proportional to the mass of the ions (see B. Chapman, "Glow Discharge Processes", John Wiley and Sons, 1980, page 70), the use of the relatively heavy ammonia-based plasma appears to be helpful in establishing a sufficiently strong local field at the surface, compared with other types of lighter-mass plasmas such as hydrogen-based plasma. This high level of tube alignment appears to be obtainable only from the high frequency plasma environment - thermal processes alone under otherwise identical conditions have yielded completely randomly oriented nanotubes. Moreover, the type of conformal alignment achieved by the invention was reportedly not achieved by processes in which a high frequency plasma is not employed, e.g., - a DC plasma assisted hot filament deposition process as practiced by Ren et al. "Large arrays of well-aligned carbon nanotubes", Proceedings of 13^{th} International Winter School on Electronic Properties of Novel Materials, 263, (1999). According to the Ren et al. process, the nanotubes do not grow conformably aligned perpendicular to the local substrate surface, but instead grow at some other angle to the surface.

In an advantageous embodiment, a microwave PECVD process is carried out under a pressure of 1333 to 13330 N/m² (10-100 Torr), with the substrate temperature at 500 to 1000°C. Total flow rates of acetylene and ammonia typically range from 30 to 30000 sccm (standard cubic centimeter per minute), and the mass flow ratio of acetylene to ammonia is typically 10 to 50%. The deposition procedure is typically performed as follows. The ammonia gas is introduced first to reach the desired pressure. The heater is then turned on to reach the desired substrate temperature, at a typical temperature ramp rate of about 40°/minute. Once the temperature is reached, the plasma is initiated, the acetylene gas is fed into the chamber, and the growth starts. Growth is typically performed from 30 seconds to 30 minutes, depending on the particular length desired. During the process shut-down, the flow of acetylene gas is stopped first, and then the plasma and heater are turned off. Once the temperature reaches room temperature, the ammonia gas is turned off, the chamber is back-filled with argon to 1 atmosphere pressure, and the substrate is removed.

Suitable substrate materials include a variety of materials, including metals, semiconductors and insulators such as Si, SiO₂, Hf, A1N, Al₂O₃, Si₃N₄, and diamond. It is possible that the substrate will, in practice, be a portion of a device, e.g., a silicon-based integrated circuit device, on which nanotube formation is desired. In addition, where silicon is used, the silicon advantageously has a thin, e.g., about 2 nm, native oxide present to impede excessive reactions between Si and the catalyst metal.

A catalyst metal is provided on the substrate, prior to the nanotube growth, to help initiate nanotube formation. (Catalyst metal includes suitable metals as well as compounds, e.g., oxides or organometallics, containing the metal.) The catalyst is generally selected from Fe, Co, Ni, or alloys thereof and is typically formed on a substrate in a thin layer. Cobalt has been found to be particularly useful. (As used herein, "layer" encompasses both continuous and patterned, i.e., discontinuous, layers.) It is possible to form the catalyst layer by any suitable thin film technique such as sputtering, evaporation, or electrodeposition. Cobalt, for example, is typically sputtered onto the substrate. The thickness of the catalyst metal films, typically 0.5 to 200 nm, substantially controls the diameter of the nanotubes. For these typical thicknesses, at least a portion of the deposited film may form an oxide of the catalyst metal. To attain a patterned layer of the catalyst, as might be useful in some device structures, it is possible to use lithographic techniques or a shadow mask during the metal deposition. For example, it is contemplated to place the catalyst metal into trenches or vias of device structures in order to grow nanotubes as device interconnections.

It is believed that nanotube growth in the process of the invention occurs according to the following model, reflected in Figs. 2A-2E, although the invention is not limited to any aspect of this proposed model. First, as shown in Fig. 2A, a catalyst metal 24 (or oxide or other compound of a suitable metal) is deposited on a native-oxide 22 covered silicon substrate 20, which for illustrative purposes has a flat surface. The presence of this thin native oxide 22 (~2 nm) on the silicon 20 is believed to be significant, in that the oxide desirably impedes reactions of the catalyst and silicon, and corresponding silicide formation, which would otherwise tend to consume the surface catalyst.

Next, as shown in Fig. 2B, during a temperature ramp up in ammonia or hydrogen gas (up to about 10 minutes), the catalyst on the surface starts to form semi-spherical shaped islands 26, driven, it appears, by thermodynamics or by surface tension to lower the total energies during heating (as confirmed by the observation of morphology evolution via scanning electron microscopy). The formation of these three-dimensional islands 26 is significant to the nucleation and growth of nanotubes and appears to be promoted by the presence of the native oxide layer 22.

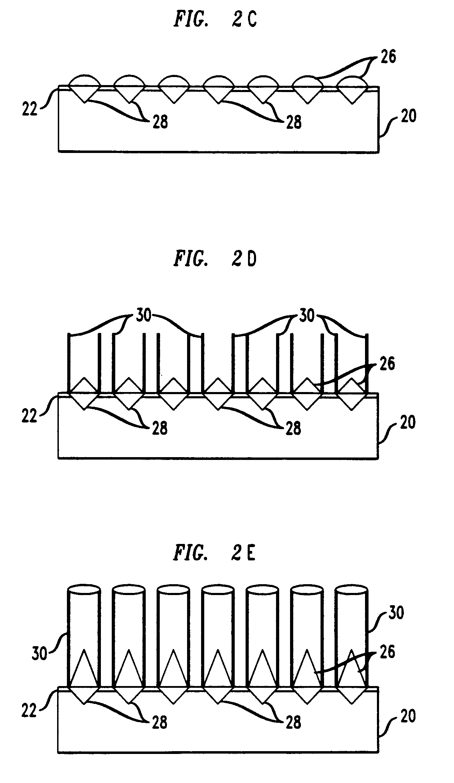

As reflected in Fig. 2C, during the later stage of the temperature ramp up and the initiation of the plasma, both the surface catalyst and the native SiO₂ are reduced, and catalyst-silicides 28 are formed at the interface. These silicides 28 appear to serve as anchors or adhesion promoters for the catalyst islands 26 formed at the surface.

As shown in Fig. 2D, during the initial stages of the NH₃-C₂H₂ high frequency PECVD, nanotubes 30 nucleate and grow from the catalyst islands 26 with field-induced orientational alignment, as discussed above. (Growth of nanotubes "from" or "on" the catalyst metal means that nanotube formation is initiated on the catalyst metal.) It is believed that the nucleation and growth occurs through carbon reactions with the catalyst, i.e., dissolution, saturation and precipitation, such that the nanotubes grow by extrusion from the base region. The catalyst islands 26 gradually transform into a conical shape and become confined to the ends of the nanotubes 30 proximate the substrate 20.

As shown in Fig. 2E, the growth of nanotubes 30 is believed to continue, both in diameter and length, until the conical shaped catalyst particles 26 are completely encased by the nanotube shells. When this encasement occurs, the growth slows significantly and the etching nature of the high frequency PECVD process begins to dominate if the sample remains exposed to the plasma. It is also possible for smaller fragments of catalyst particles to be trapped at various locations along the tubes.

The nanotube growth, according to the invention, and consistent with this model, is controllable at least as to orientational alignment, diameter, length and location of the nanotubes.

The orientational alignment, as discussed, is provided by the electrical self-bias potential created by the high frequency PECVD process, particularly with the acetylene-ammonia chemistry, or similar chemistries involving relatively large ions.

The diameter of nanotubes is controllable by selecting a particular catalyst layer thickness. For example, by varying the thickness of a cobalt layer from 2 nm to 60 nm, the nanotube diameter goes from about 30 nm to about 150 nm. Consistent with the model, the size of the catalyst islands is determined, as least in part, by the thickness of the catalyst layer, with thin layers leading to smaller diameter islands, and thicker layers leading to larger diameter islands. The range of nanotube diameters typically attainable is 10 to 300 nm. Control runs are easily performed to determine an appropriate catalyst layer thickness for a desired nanotube diameter.

The nanotube length is primarily controlled by the duration of the high frequency PECVD process, but not in a monotonically linear fashion. As noted in Example 5 below, there are three stages of the process as it affects length - growth, stability, and etch. Specifically, length initially increases for a certain time period (about 5 minutes from the initiation of the process for the experiments detailed below). This growth stage is followed by a period of substantially slowed growth - the stability stage. And then the nanotubes begin to be etched away such that the length is reduced - the etch stage. It appears, consistent with the model, that at some point during nanotube growth catalyst particles become completely encased by graphitic shells. Once the catalyst is so encased, nanotube growth slows (stability stage), and the etching character of the high frequency PECVD process begins to predominate (etch stage). It is also possible that the increasing length of the nanotubes interferes with the ability of reactive species to reach the catalyst at the bottom of the growing tube, thereby slowing the growth. Thus, for a given set of high frequency PECVD process parameters, the duration will typically be chosen to attain a desired length, without entering into the etch stage. However, it is possible to reach any of the three stages, and it is possible for certain advantages to exist in each. For example, it is possible that moving at least partially into the etch stage will provide nanotubes with open, as opposed to capped, ends, which may be desirable for some applications. Typical lengths attainable with the process of the invention range from 0.5 to 30 µm. Control runs are easily performed to find a suitable process duration to provide a desired length.

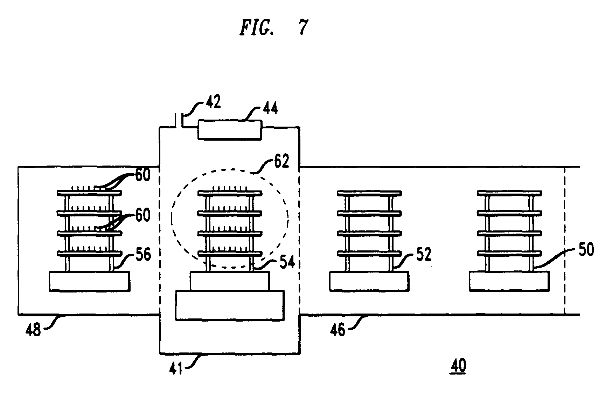

The high growth rate of the process, e.g., as high as 5 µm per minute (in terms of nanotube height), is about 30 times higher than plasma-free thermal CVD processes with identical deposition conditions. To take further advantage of this high rate, it is possible to use a continuous or semi-continuous PECVD process, optionally with multiple substrates on which nanotubes are formed simultaneously. For example, Fig. 7 shows one such apparatus 40. The apparatus 40 contains a reaction chamber 41 (both closed-reactor and open-reactor types of PECVD are possible), gas supply and control systems (e.g., gas inlet 42), a plasma generating circuit 44, multiple-substrate support stands 50, 52, 54, 56, continuous or semi-continuous feed systems (e.g., load chamber 46 and unloading chamber 48), as well as other components apparent to one skilled in the art. The high speed fabrication of the nanotubes 60 is able to be performed on single- or double-sided substrates, in a plasma 62 large enough to cover all the substrates. Advantageously, the plasma exhibits an average diameter of at least 20 cm, more advantageously at least 40 cm. The resultant growth rate according to this increased-speed apparatus, per 1 µm height of nanotubes, is advantageously at least 0.01 x 10⁶ cm² per hour, more advantageously at least 0.5 x 10⁶ cm² per hour.

The invention will be further clarified by the following examples, which are intended to be exemplary.

### Experimental

The microwave PECVD system used in the examples consisted of a 2.45-GHz 5kW microwave power supply with a rectangular waveguide coupled to a cylindrical growth cavity, a 6-inch inner-diameter stainless-steel chamber, and a molybdenum substrate stage with a RF heater that allowed independent control of the substrate temperature from the plasma power. During processing, the substrate temperature was maintained at 825°C, and the chamber pressure was kept at 20 torr (or 2666 N/m²). Total gas flow rates of acetylene (C₂H₂) and ammonia (NH₃) were controlled at 200 sccm, and the mass flow ratio of C₂H₂ over NH₃ was varied in the range of 10-30%.

The nanotubes were grown by microwave PECVD on cobalt-coated silicon substrates or silica fibers. The cobalt was applied by DC magnetron sputtering at a power density of 9 W/cm², and was apparently oxidized due to the very thin nature of the coating. The microwave PECVD typically lasted from 30 seconds to 30 minutes.

### Example 1

A 2 nm thick cobalt layer was deposited onto a silicon substrate. The microwave PECVD process was performed for 2 minutes at a C₂H₂/NH₃ mass flow ratio of 20%. Fig. 3 shows a scanning electron microscope micrograph of the resultant nanotubes, which were multiwalled nanotubes having diameters of about 30 nm and lengths of about 10 µm. X-ray diffraction measurements indicated an average deviation of the tubes from the normal to the surface of less than 10°. For a cold microwave plasma (cold indicating that the temperature of ions and neutrals is much lower - near room temperature - than the electron temperature which can be tens of thousands of degrees) of ammonia and acetylene mixture at 1 kW microwave input power and 20 torr (2666 N/m²) pressure, the self-bias potential created by the PECVD process is estimated to be 10 V across a sheath of 100 µm. This would generate a field of 0.1 V/µm in the vicinity of the surface, which is sufficient to align the nanotubes.

### Example 2

To confirm the affect of the self-bias potential, and the conformal perpendicular alignment on flat surface, a process identical to Example 1 was performed in which flat silicon substrates were placed in either a vertical or tilted position, in addition to the normal horizontal position, on the substrate stage. The nanotubes grew perpendicular to the substrate surface regardless of the substrate position.

### Example 3

To confirm the ability to form conformably aligned nanotubes perpendicular to the local surface of non-flat substrates, the process of claim 1 was performed on a telecommunications-grade, 125 µm diameter silica optical fiber. Figs. 4A and 4B show the resultant structure, in which the nanotubes point radially outward perpendicular to the local surface. This result shows the dominating role of the local DC electrical self-bias field in attaining the conformal alignment of the nanotubes.

### Example 4

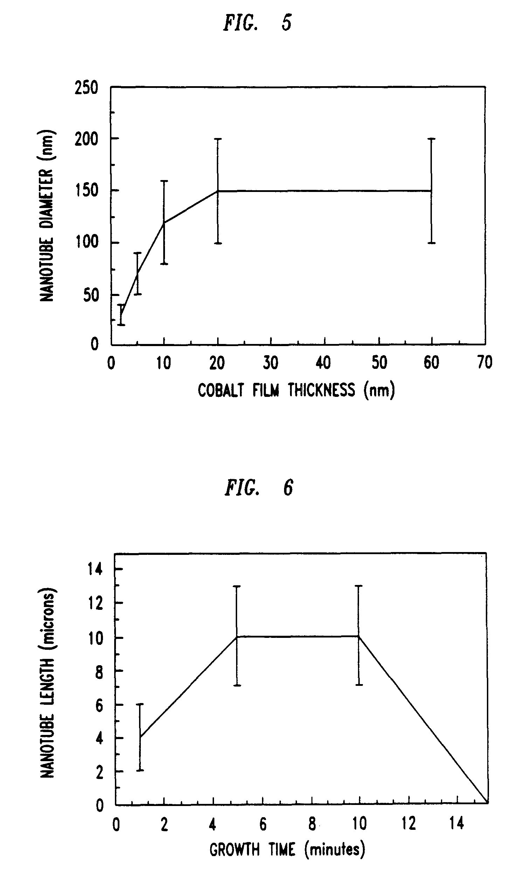

The deposition procedure of Example 1 was followed for cobalt layers having thicknesses (in addition to the 2 nm layer of Example 1) of 5, 10, 20, and 60 nm to examine the effect of the thickness on nanotube diameter. As shown in Fig. 5, the average diameter of nanotubes increased as the cobalt thickness increased. Above a cobalt thickness of 20 nm, the nanotube diameter appeared to become saturated at about 150 nm under the particular growth conditions.

### Example 5

Following the procedure of Example 1, again with a cobalt layer thickness of 2 nm, nanotube length was monitored for varying process times. As shown in Fig. 6, there were three stages - growth, stability, and etch. The average growth rate in terms of tube length for the first 5 minutes was about 1 µm/minute. Above 5 minutes, growth slowed, and at around 10 minutes, nanotube length decreased. (These results are specific to the particular growth conditions.)

Other embodiments of the invention will be apparent to those skilled in the art from consideration of the specification and practice of the invention disclosed herein.

## Claims

1. A process for fabricating an article, comprising the steps of:
providing a substrate, the substrate comprising a flat or non-flat surface with a catalyst metal layer thereon;
forming carbon nanotubes on the catalyst metal layer by a plasma enhanced chemical vapor deposition process with a gaseous carbon-based chemistry, such that the resultant nanotubes are conformably aligned perpendicular to the local substrate surface.

2. The process of claim 1, wherein the plasma is induced by a high frequency source.

3. The process of claim 2, wherein the high frequency is an RF or a microwave frequency.

4. The process of claim 3, wherein the frequency is 915 MHz, 2.45 GHz, or 13.56 MHz.

5. The process of claim 2, wherein the plasma enhanced chemical vapor deposition is performed with a chemistry comprising ammonia.

6. The process of claim 5, wherein the plasma enhanced chemical vapor deposition is performed with a chemistry comprising ammonia and acetylene.

7. The process of claim 6, wherein the mass flow ratio of acetylene to ammonia is 10 to 50%.

8. The process of claim 1, wherein the substrate comprises a material selected from the group consisting of silicon, silica, Hf, AlN, Al₂O₃, Si₃N₄ and diamond, and the catalyst metal layer comprises an element selected from the group consisting of cobalt, nickel, iron, and alloys thereof.

9. The process of claim 8, wherein the catalyst metal layer is present in a thickness of 0.5 to 200 nm.

10. The process of claim 8, wherein the substrate comprises silicon or silicon oxide and the catalyst metal layer comprises cobalt.

11. The process of claim 9, wherein the average nanotube diameter is 10 to 300 nm.

12. The process of claim 1, wherein the nanotubes have an average length of 0.5 to 30 µm.

13. The process of claim 1, wherein at least a portion of the nanotubes comprise one or more encased catalyst metal particles.

14. The process of claim 13, wherein the encased catalyst metal particles are located proximate the substrate surface.

15. The process of claim 1, wherein the catalyst metal layer is a patterned layer, such that the nanotubes form in the pattern.

16. The process of claim 1, wherein the catalyst metal thickness controls the nanotube diameter.

17. The process of claim 2, wherein the high frequency plasma enhanced chemical vapor deposition process exhibits stages of growth, stability, and etch as to nanotube length.

18. The process of claim 1, wherein the plasma enhanced chemical vapor deposition induces formation of distinct islands of the catalyst metal, the nanotube growth initiating on such islands.

19. The process of claim 1, wherein the growth rate of the nanotubes in height is at least 5 µm per minute.

20. The process of claim 19, wherein the growth rate per 1 µm height of nanotubes is at least 0.01 x 10⁶ cm² per hour.
